# EUROPEAN PATENT APPLICATION

(11) **EP 4 319 518 A1**
(43) Date of publication of application: **07.02.2024**
(21) Application number: 22784343.0
(22) Date of filing: 15.02.2022
(51) Int. Cl.: H05K 7/20, H02M 7/48

(54) **CASING AND POWER CONVERSION DEVICE**

(30) Priority: 06.04.2021 JP 2021064920
(71) Applicant: Mitsubishi Heavy Industries, Ltd., Tokyo 100-8332 (JP)
(72) Inventor: ONO, Kimihiro, Tokyo 100-8332 (JP)
(74) Representative: Studio Torta S.p.A.
(86) International application number: PCT/JP2022/005915
(87) International publication number: WO 2022/215358

(57) **Abstract**

A casing of the present disclosure is a casing of a power conversion device with a capacitor and a power module, including: a coolant flow path forming portion in which a flow path of coolant is formed; a capacitor storage portion which is integrally formed with a part of the coolant flow path forming portion and in which a capacitor storage space of the capacitor is formed; and a cover portion defining a power module storage space storing at least the power module together with the remainder of the coolant flow path forming portion and the capacitor storage portion, wherein the coolant flow path forming portion includes a capacitor cooling unit which is configured to cool the capacitor storage portion and a power module cooling unit which is configured to cool the power module.

## Description

### Technical Field

The present disclosure relates to a casing and a power conversion device.

Priority is claimed on Japanese Patent Application No. 2021-64920, filed April 6, 2021, the content of which is incorporated herein by reference.

### Background Art

In power conversion devices such as inverters, a coolant such as cooling water may be used to cool a power module. Further, in such power conversion devices, the temperature of a capacitor may rise in addition to the power module and the capacitor may also need to be cooled.

Patent Document 1 discloses a structure in which a cooling water channel is provided around a capacitor provided inside a casing of a power conversion device to cool the capacitor.

### Citation List

### Patent Document(s)

Patent Document 1: Japanese Unexamined Patent Application, First Publication No. 2015-156798

### Summary of Invention

### Technical Problem

However, when the cooling water channel is provided around the capacitor as in the power conversion device of Patent Document 1, a space for providing the cooling water channel dedicated for the capacitor is required and hence a problem arises in that the casing of the power conversion device increases in size.

The present disclosure has been made in view of the above-described circumstances and an object thereof is to provide a casing and a power conversion device capable of suppressing an increase in size while efficiently cooling a capacitor.

### Solution to Problem

A casing according to a first aspect of the present disclosure is a casing of a power conversion device with a capacitor and a power module, including: a coolant flow path forming portion in which a flow path of coolant is formed; a capacitor storage portion which is integrally formed with a part of the coolant flow path forming portion and in which a capacitor storage space of the capacitor is formed; and a cover portion defining a power module storage space storing at least the power module together with the remaining part of the coolant flow path forming portion and the capacitor storage portion, wherein the coolant flow path forming portion includes a capacitor cooling unit which is configured to cool the capacitor storage portion and a power module cooling unit which is configured to cool the power module.

A power conversion device according to a second aspect of the present disclosure includes: the above mentioned casing; a capacitor which is stored in the capacitor storage space; and a power module which is stored in the power module storage space.

### Advantageous Effects of Invention

According to a casing and a power conversion device of the present disclosure, it is possible to suppress an increase in size while efficiently cooling a capacitor.

### Brief Description of Drawings

FIG. 1 is a perspective view of a power conversion device of a first embodiment of the present disclosure.
FIG. 2 is a perspective view of the power conversion device of the first embodiment of the present disclosure and shows a state in which a cover is removed.
FIG. 3 is a perspective view of the power conversion device of the first embodiment of the present disclosure and shows a state in which a control board and a current sensor of FIG. 2 are removed.
FIG. 4 is a bottom view of the power conversion device of FIG. 1.
FIG. 5 is a perspective view showing a state in which a lid of FIG. 4 is removed.
FIG. 6 is a perspective view showing a partial cross-section of a capacitor storage portion of the first embodiment of the present disclosure.
FIG. 7 is a partially cross-sectional view of a coolant flow path forming portion of a second embodiment of the present disclosure.
FIG. 8 is a main enlarged view of FIG. 7.

### Description of Embodiments

### First Embodiment

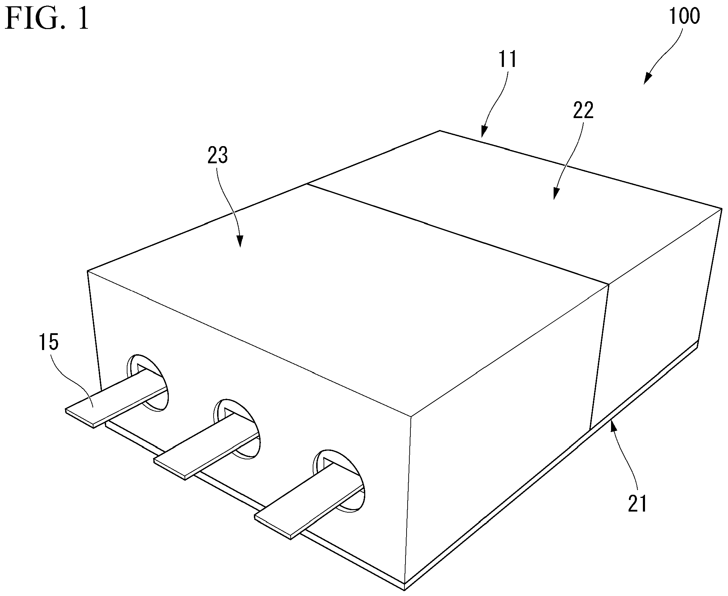

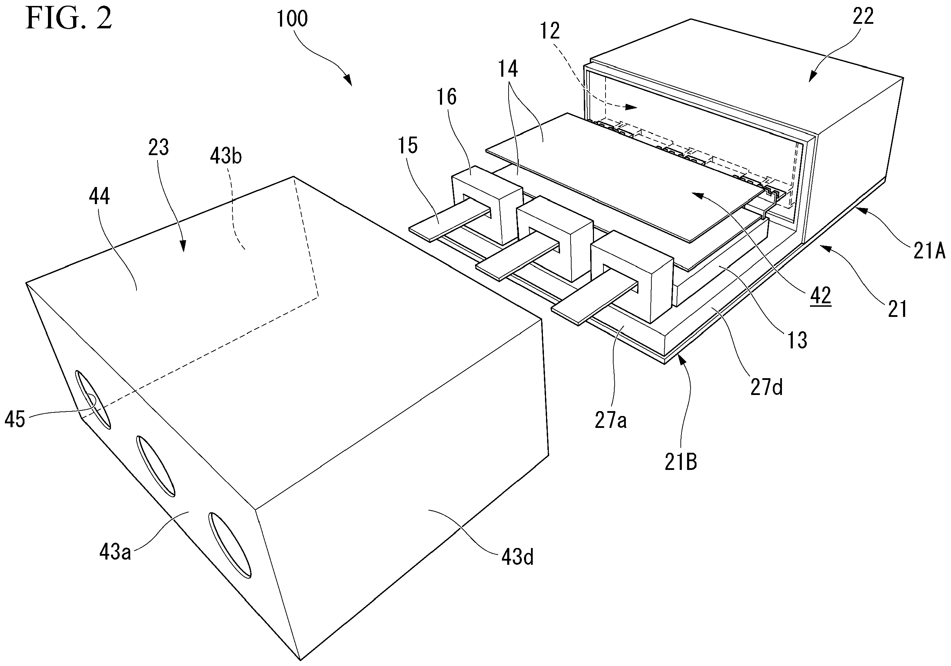

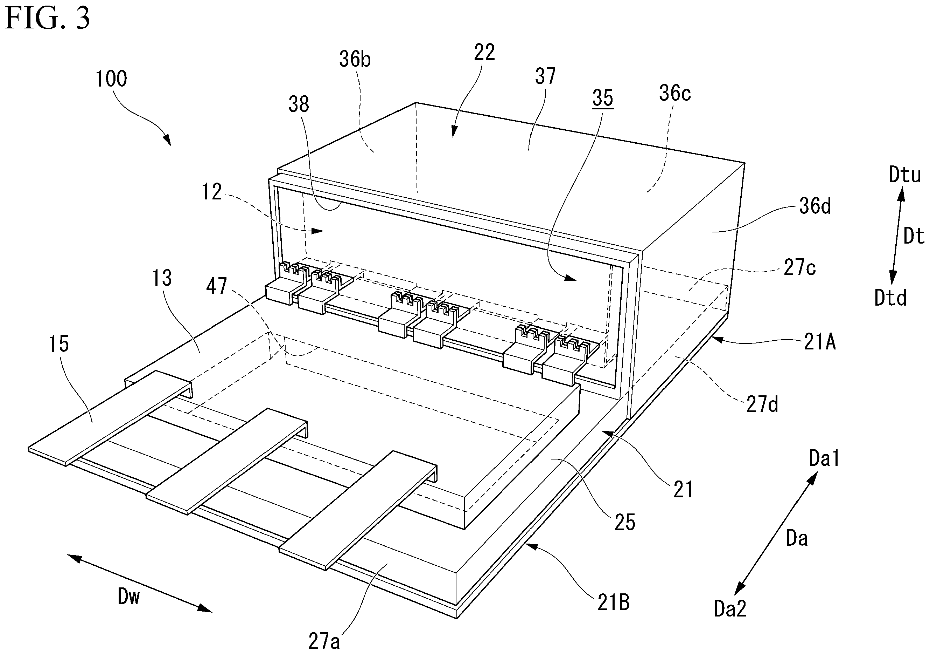

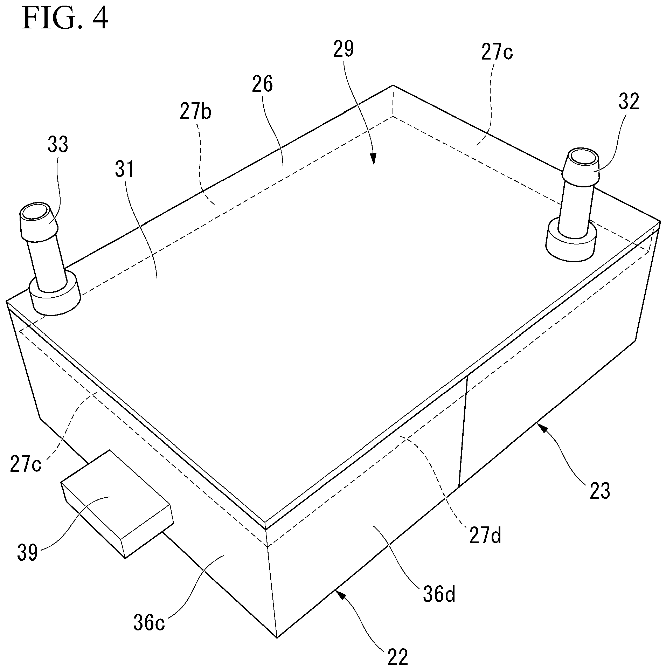

Next, a casing and a power conversion device of a first embodiment of the present disclosure will be described with reference to the drawings. FIG. 1 is a perspective view of the power conversion device of the first embodiment of the present disclosure. FIG. 2 is a perspective view of the power conversion device of the first embodiment of the present disclosure and shows a state in which a cover is removed. FIG. 3 is a perspective view of the power conversion device of the first embodiment of the present disclosure and shows a state in which a control board and a current sensor of FIG. 2 are removed. FIG. 4 is a bottom view of the power conversion device of FIG. 1.

A power conversion device 100 of the first embodiment is the power conversion device 100 used as an inverter for converting DC power into AC power, a converter for converting AC power into DC power, or the like. This power conversion device 100 can be used, for example, as a power conversion device or the like that controls a three-phase brushless motor that is a drive source of an electric vehicle.

As shown in FIGS. 1 and 2, the power conversion device 100 of this embodiment includes a casing 11, a capacitor 12, a power module 13, a control board 14, a bus bar 15, and a current sensor 16.

The casing 11 is for storing each of the capacitor 12, the power module 13, the control board 14, and the current sensor 16. The casing 11 can be formed of, for example, metal or synthetic resin having high thermal conductivity. The casing 11 includes a coolant flow path forming portion 21, a capacitor storage portion 22, and a cover portion 23.

The coolant flow path forming portion 21 constitutes a flow path R (which will be described later) through which a coolant flows. As shown in FIGS. 1 and 3, the coolant flow path forming portion 21 of this embodiment includes a first wall portion 25 and a second wall portion 26 each having a rectangular outline in plan view. The coolant flow path forming portion 21 further includes four side walls 27a to 27d which connect the first wall portion 25 and the second wall portion 26. Additionally, in the following description, the direction in which the long sides of the first wall portion 25 and the second wall portion 26 of the coolant flow path forming portion 21 extend is referred to as the longitudinal direction Da and the direction in which the short sides of the rectangle extend is referred to as the width direction Dw. Further, the direction perpendicular to the first wall portion 25 and the second wall portion 26 is referred to as the thickness direction Dt, the side away from the first wall portion 25 in the thickness direction is referred to as the first side Dtu in the thickness direction, and the side away from the second wall portion 26 is referred to as the second side Dtd in the thickness direction.

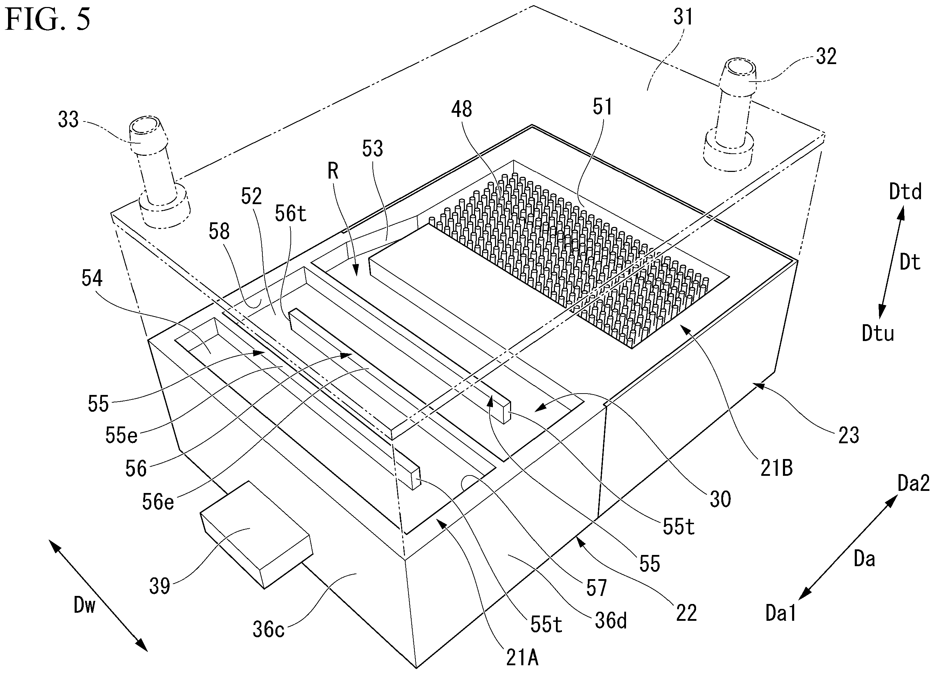

FIG. 5 is a perspective view showing a state in which a lid of FIG. 4 is removed.

As shown in FIGS. 4 and 5, the coolant flow path forming portion 21 of this embodiment includes a coolant flow path forming portion body 28 and a lid portion 29. The coolant flow path forming portion body 28 includes a flow path recess portion 30 which opens to the side of the second wall portion 26. The lid portion 29 includes a lid body 31 which is formed in a flat plate shape and a coolant inlet 32 and a coolant outlet 33 which are attached to the lid body 31. The lid body 31 blocks the flow path recess portion 30. The lid body 31 of this embodiment constitutes the second wall portion 26 of the coolant flow path forming portion 21 while blocking the flow path recess portion 30 of the coolant flow path forming portion body 28.

Each of the coolant inlet 32 and the coolant outlet 33 extends from the lid body 31 to the second side in the thickness direction. The coolant inlet 32 and the coolant outlet 33 communicate with the inside and the outside of the coolant flow path forming portion 21. The coolant inlet 32 is an inlet for supplying a coolant to the flow path R formed inside the coolant flow path forming portion 21 and the coolant outlet 33 is an outlet for discharging the coolant flowed through the flow path R formed inside the coolant flow path forming portion 21 to the outside of the coolant flow path forming portion 21. The coolant inlet 32 and the coolant outlet 33 of this embodiment are arranged at diagonal positions of the rectangle in plan view in the lid body 31. That is, when the coolant flows from the coolant inlet 32, the coolant flows through the flow path R inside the coolant flow path forming portion 21 and then is discharged from the coolant outlet 33 to the outside of the coolant flow path forming portion 21.

As shown in FIG. 3, the capacitor storage portion 22 constitutes a capacitor storage space 35 which stores the capacitor 12. The capacitor storage portion 22 is integrally formed with a part of the coolant flow path forming portion 21. Specifically, the capacitor storage portion 22 constitutes the capacitor storage space 35 storing the capacitor 12 together with the first wall portion 25 of the coolant flow path forming portion 21. The capacitor storage portion 22 of this embodiment includes two traverse side walls 36b and 36d which extend toward the first side Dtu in the thickness direction in parallel to a side wall 27b (see FIG. 4) and a side wall 27d located on both sides of the coolant flow path forming portion 21 in the width direction Dw, one longitudinal side wall 36c which extends toward the first side Dtu in the thickness direction in parallel to the side wall 27c located on the first side Da1 in the longitudinal direction Da of the coolant flow path forming portion 21, edge portions of these traverse side walls 36b and 36d on the first side Dtu in the thickness direction, and a ceiling wall 37 which connects the edge portions of the longitudinal side wall 36c on the first side Dtu in the thickness direction and extends in the longitudinal direction Da and the width direction Dw.

The capacitor storage portion 22 further includes an opening portion 38 on the side opposite to the longitudinal side wall 36c in the longitudinal direction Da. This opening portion 38 faces the second side Da2 in the longitudinal direction Da. The capacitor 12 can be stored in the capacitor storage space 35 inside the capacitor storage portion 22 through this opening portion 38. Additionally, the longitudinal side wall 36c of this embodiment is provided with a terminal portion 39 for electrically connecting the capacitor 12 and the outside of the capacitor storage portion 22.

The capacitor storage portion 22 of this embodiment is provided with a partition wall 41 which divides the capacitor storage space 35 into a plurality of sections. These partition walls 41 are connected to at least one of the traverse side walls 36b and 36d, the longitudinal side wall 36c, the ceiling wall 37, and the coolant flow path forming portion body 28. In other words, the heat transferred to the partition wall 41 is indirectly transferred to the coolant flow path forming portion body 28 via the traverse side walls 36b and 36d, the longitudinal side wall 36c, and the ceiling wall 37 or is directly transferred to the coolant flow path forming portion body 28. The partition wall 41 of this embodiment is provided with a through hole (not shown) and a wiring (not shown) connected to the capacitor 12 is inserted through the through hole. Additionally, the partition wall 41 may be provided appropriately or may be omitted.

As shown in FIG. 2, the cover portion 23 defines at least a power module storage space 42 storing the power module 13 together with the remainder of the coolant flow path forming portion 21 not provided with the capacitor storage portion 22 and the capacitor storage portion 22. Here, the remainder of the coolant flow path forming portion 21 is a portion excluding a portion integrally formed with the capacitor storage portion 22 in the coolant flow path forming portion 21. The cover portion 23 is attachable to and detachable from the coolant flow path forming portion 21 and the capacitor storage portion 22.

The cover portion 23 of this embodiment includes two traverse cover side walls 43b and 43d which extend to the first side Dtu in the thickness direction in parallel to the side walls 27b and 27d in the width direction Dw of the remainder of the coolant flow path forming portion 21 while being attached to the remainder of the coolant flow path forming portion 21 and the capacitor storage portion 22 to define the power module storage space 42 (in other words, in a blocked state), one longitudinal cover side wall 43a which extends to the first side Dtu in the thickness direction in parallel to the side wall 27a located on the second side Da2 in the longitudinal direction Da of the coolant flow path forming portion 21, edge portions of the traverse cover side walls 43b and 43d on the first side Dtu in the thickness direction, and a cover ceiling wall 44 which connects the edge portions of the longitudinal cover side wall 43a on the first side in the thickness direction and extends in the longitudinal direction Da and the width direction Dw.

The longitudinal cover side wall 43a is provided with a plurality of through holes 45 through which a conductor such as a bus bar 15 electrically connecting the power module 13 and the outside of the casing 11 passes. Then, each penetrating current sensor 16 is attached to the bus bar 15 of this embodiment and these current sensors 16 are stored in the power module storage space 42 together with the power module 13. Further, in this embodiment, the control board 14 controlling the operation of the power module 13 is also stored in the power module storage space 42.

In the coolant flow path forming portion 21 of this embodiment, part of the coolant flow path forming portion 21 integrally formed with the capacitor storage portion 22 constitutes a capacitor cooling unit 21A and the remainder of the coolant flow path forming portion 21 excluding the capacitor cooling unit 21A constitutes a power module cooling unit 21B.

The capacitor 12 removes, for example, high-frequency components from the external power input to the power conversion device 100. As the capacitor 12 of this embodiment, for example, a film capacitor can be exemplified. The power conversion device 100 of this embodiment includes the plurality of capacitors 12 and all of these capacitors 12 are stored in the capacitor storage portion 22.

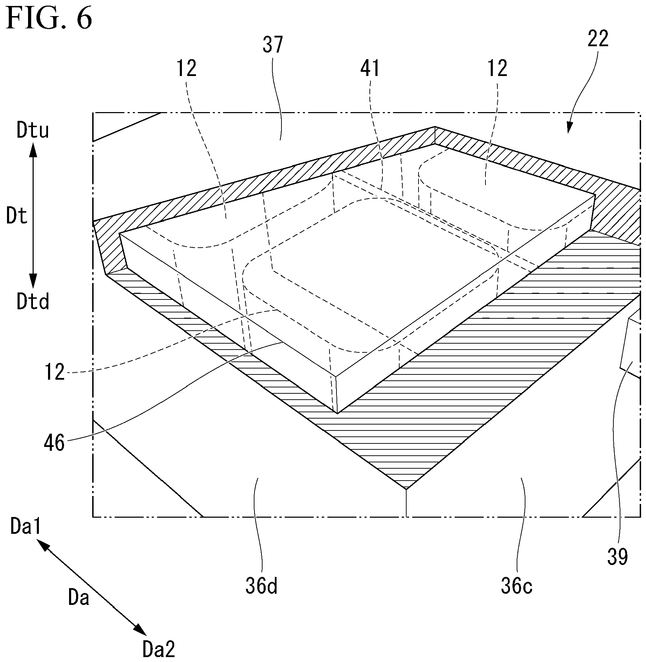

FIG. 6 is a perspective view showing a partial cross-section of the capacitor storage portion of the first embodiment of the present disclosure.

As shown in FIG. 6, the capacitor storage portion 22 of this embodiment is filled with a filler 46 having exceptional thermal conductivity and high electrical insulation properties while storing the capacitor 12. That is, the filler 46 is in close contact with the outer surface of the capacitor 12 and the heat of the capacitor 12 is transferred to the capacitor storage portion 22 and the coolant flow path forming portion 21 via the filler 46. As the filler 46 filled in the capacitor storage portion 22, for example, the filler 46 which flows into the capacitor storage portion 22 in a liquid state and then is solidified can be used.

In the power module 13, a plurality of power semiconductor elements such as surface-mounted power MOSFETs and IGBTs are mounted on a circuit board. As shown in FIG. 3, the power module 13 capable of outputting three-phase power is exemplified in this embodiment. The power module 13 is installed inside the power module storage space 42 of the casing 11. More specifically, the power module 13 of this embodiment is fixed to the surface of the remainder of the coolant flow path forming portion 21. Then, the power module 13 of this embodiment is installed in a posture in which the extension direction of the circuit board matches the extension direction of the first wall portion 25 of the coolant flow path forming portion 21.

Here, the power module cooling unit 21B which is the remainder of the coolant flow path forming portion 21 includes a communication opening portion 47 which is formed on the surface of the coolant flow path forming portion body 28 to allow the power module storage space 42 and the flow path R inside the coolant flow path forming portion 21 to communicate with each other. The power module 13 of this embodiment is formed to be larger than the communication opening portion 47 and is fixed to the coolant flow path forming portion 21 to block the communication opening portion 47. Additionally, the periphery of the communication opening portion 47 is sealed so that the coolant does not leak from the gap between the communication opening portion 47 and the power module 13.

As shown in FIG. 5, the power module 13 further includes a cooling fin 48 for cooling a power semiconductor element. The cooling fin 48 is fixed to the rear surface of the circuit board facing the side opposite to the mounting surface of the power semiconductor element. The cooling fin 48 is electrically insulated from the circuit board and heat emitted from the power semiconductor element is transferred thereto. At least a part of the cooling fin 48 is located inside the flow path R of the coolant flow path forming portion 21 via the communication opening portion 47 of the coolant flow path forming portion 21. That is, the power semiconductor element and the coolant can indirectly exchange heat therebetween via the cooling fin 48 and the circuit board.

As shown in the drawings, the power module cooling unit 21B of the coolant flow path forming portion 21 includes a module cooling flow path 51 which communicates with the communication opening portion 47 as the flow path R. The cooling fin 48 of the power module 13 is disposed in this module cooling flow path 51. This module cooling flow path 51 is formed at a position overlapping the coolant inlet 32 when viewed from the thickness direction Dt and the coolant flows from the coolant inlet 32. The module cooling flow path 51 of this embodiment has the same rectangular shape as that of the communication opening portion 47 when viewed from the thickness direction Dt. Further, the module cooling flow path 51 of this embodiment has a rectangular shape elongated in the width direction Dw. Further, the module cooling flow path 51 of this embodiment is sandwiched between the cooling fin 48 and the lid portion 29 in the thickness direction Dt. Additionally, the module cooling flow path 51 is not limited to the above-described shape and may be appropriately formed according to, for example, the shape of the cooling fin 48.

The capacitor cooling unit 21A includes a capacitor cooling flow path 52 which communicates with the downstream side of the module cooling flow path 51 of the power module cooling unit 21B. The capacitor cooling flow path 52 of this embodiment communicates with the module cooling flow path 51 via a connection flow path 53 located on one side in the width direction Dw and extending in the longitudinal direction. The capacitor cooling flow path 52 includes a capacitor flow path recess portion 54 which is the flow path recess portion 30, a first flow path wall 55 which extends from one side to the other side in the width direction Dw, and a second flow path wall 56 which extends from the other side to one side in the width direction Dw. An end portion 55t of the first flow path wall 55 is separated from an edge portion 57 on the other side in the width direction Dw of the capacitor flow path recess portion 54 and an end portion 56t of the second flow path wall 56 is separated from an edge portion 58 on one side in the width direction Dw of the capacitor flow path recess portion 54. Then, the first flow path wall 55 and the second flow path wall 56 are alternately formed at intervals in the longitudinal direction Da. Further, edge portions 55e and 56e of the first flow path wall 55 and the second flow path wall 56 on the side of the lid portion 29 are respectively in close contact with the lid portion 29. That is, the coolant flowing through the capacitor cooling flow path 52 of the capacitor cooling unit 21A flows to the first side in the width direction Dw, flows to the second side in the width direction Dw, and then flows to the first side in the width direction Dw. In this way, the coolant flows in a meandering manner while changing direction repeatedly.

### (Operation and effect)

The casing 11 of the first embodiment includes the coolant flow path forming portion 21, the capacitor storage portion 22, and the cover portion 23. The coolant flow path forming portion 21 forms the flow path R through which the coolant flows. The capacitor storage portion 22 is integrally formed with a part of the coolant flow path forming portion 21 and forms the capacitor storage space 35 storing the capacitor 12. The cover portion 23 defines at least the power module storage space 42 storing the power module 13 together with the remainder of the coolant flow path forming portion 21 and the capacitor storage portion 22. Then, the coolant flow path forming portion 21 includes the capacitor cooling unit 21A which cools the capacitor storage portion 22 and the power module cooling unit 21B which cools the power module 13.

According to such a casing 11, it is possible to cool both the capacitor 12 and the power module 13 by the coolant flow path forming portion 21. Further, since the capacitor storage portion 22 and part of the coolant flow path forming portion 21 are integrally formed with each other, it is possible to define the capacitor storage space 35 by efficiently using a part of the coolant flow path forming portion 21. Further, since the power module storage space 42 is formed by efficiently using the remainder of the coolant flow path forming portion 21 and the capacitor storage portion 22 in addition to the cover portion 23, it is possible to form the power module storage space 42 in a compact size. Further, since it is possible to form the outer shell of the casing 11 by the cover portion 23, the capacitor storage portion 22, and the coolant flow path forming portion 21, it is not necessary to separately provide a casing that covers the capacitor cooling structure from the outside. Thus, it is possible to suppress an increase in size while efficiently cooling the capacitor 12.

The power module cooling unit 21B of the first embodiment further includes the communication opening portion 47 which allows the power module storage space 42 and the flow path R to communicate with each other.

According to such a casing 11, it is possible to allow the cooling fin 48 of the power module 13 to directly contact the coolant and to more efficiently cool the power module 13.

The cover portion 23 of the first embodiment includes a through hole 45 through which the bus bar 15 connected to the power module 13 is able to pass. Then, the power module storage space 42 is able to store the current sensor 16 that measures a current flowing through the bus bar 15.

Thus, since it is possible to store the current sensor 16 in the power module storage space 42, it is also possible to cool the current sensor 16 by allowing, for example, the current sensor 16 to contact the coolant flow path forming portion 21. Thus, since the installation space is small compared to the case in which a cooling mechanism for cooling the current sensor 16 is separately provided, it is possible to improve the degree of freedom when installing the casing 11.

The capacitor storage portion 22 of the first embodiment includes the partition wall 41 which divides the capacitor storage space 35 into a plurality of sections.

With such a configuration, the heat of the capacitor 12 stored in the capacitor storage portion 22 is transferred to the capacitor cooling unit 21A via the partition wall 41. Thus, it is possible to more efficiently cool the capacitor 12.

The capacitor storage space 35 of the first embodiment is filled with the filler 46.

With such a configuration, the filler 46 contacts the periphery of the capacitor 12 and the filler 46 contacts the capacitor cooling unit 21A and each wall portion (the traverse side walls 36b and 36d and the ceiling wall 37) of the capacitor storage portion 22. Therefore, since the heat of the capacitor 12 is transferred to each wall portion and the capacitor cooling unit 21A via the filler 46, it is possible to further improve the cooling efficiency compared to the case in which the filler 46 is not filled.

### Second Embodiment

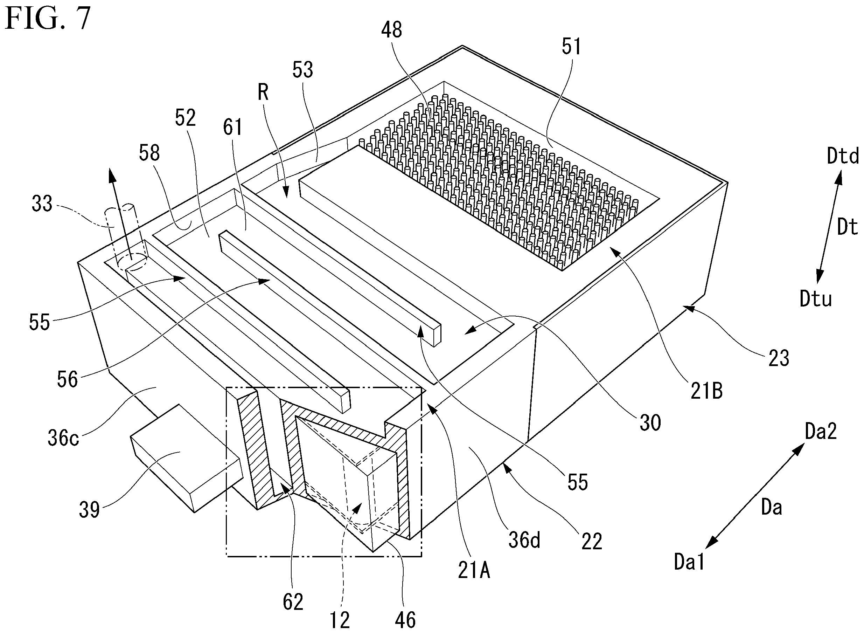

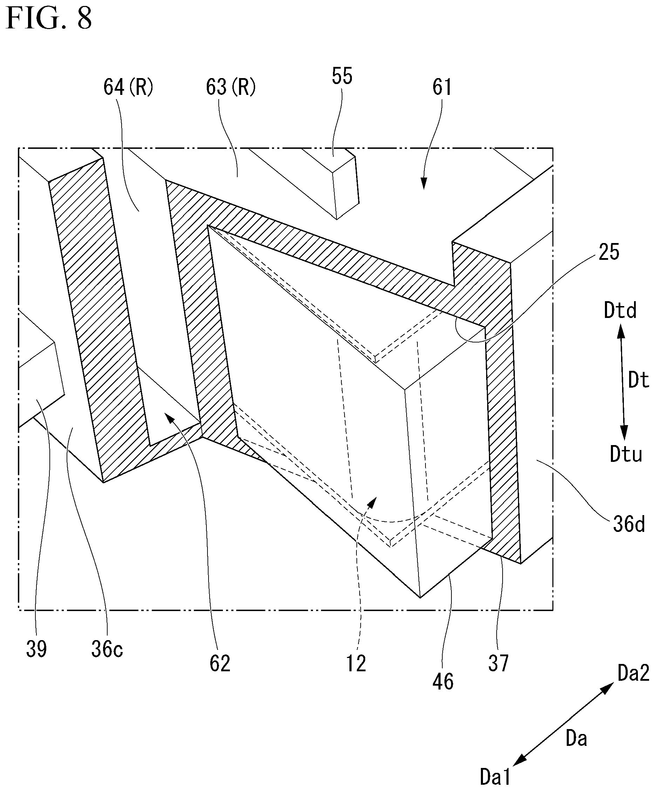

Next, a second embodiment of the present disclosure will be described with reference to the drawings. The casing of the second embodiment is different from the casing 11 of the first embodiment only in the configuration of the cooling flow path forming portion. Therefore, the same parts as those of the first embodiment will be indicated by the same reference numerals, and redundant description will be omitted. FIG. 7 is a partially cross-sectional view of the coolant flow path forming portion of the second embodiment of the present disclosure. FIG. 8 is a main enlarged view of FIG. 7.

The power conversion device of this second embodiment includes the casing 11, the capacitor 12, the power module 13, the control board 14, the bus bar 15, and the current sensor 16 similarly to the power conversion device 100 of the first embodiment. Further, the casing 11 of the second embodiment includes the coolant flow path forming portion 21, the capacitor storage portion 22, and the cover portion 23.

As shown in FIG. 7, the coolant flow path forming portion 21 of this second embodiment includes the capacitor cooling unit 21A which is integrally formed with the capacitor storage portion 22 and the power module cooling unit 21B which cools the power module 13 similarly to the coolant flow path forming portion 21 of the first embodiment.

Further, as shown in FIGS. 7 and 8, the capacitor cooling unit 21A of this second embodiment includes a first flow path forming portion 61 and a second flow path forming portion 62. The first flow path forming portion 61 forms a first flow path 63 along the first wall portion 25 of the coolant flow path forming portion 21. The second flow path forming portion 62 communicates with the first flow path forming portion 61 and forms the second flow path 64 along the longitudinal side wall 36c of the capacitor storage portion 22. The second flow path forming portion 62 is integrally formed with the longitudinal side wall 36c of the capacitor storage portion 22. The second flow path forming portion 62 of this second embodiment forms the flow path R which extends from the most first side Da1 in the longitudinal direction to the first side Dtu in the thickness direction in the first flow path forming portion 61. Part of the coolant flowed through the first flow path 63 flows into the second flow path 64 formed by the second flow path forming portion 62. The coolant flowing into the second flow path 64 is discharged to the outside of the coolant flow path forming portion 21 from the coolant outlet 33 together with the coolant not flowing into the second flow path 64. Additionally, although a case has been described in which the second flow path 64 is formed along the longitudinal side wall 36c, the second flow path 64 is not limited to the case in which the second flow path is formed along the longitudinal side wall 36c. The second flow path 64 may be formed along, for example, one of two traverse side walls 36b and 36d. That is, the second flow path 64 may be formed along any one side wall among two traverse side walls 36b and 36d and the longitudinal side wall 36c. Furthermore, the second flow path 64 may be formed along any two or all side walls among two traverse side walls 36b and 36d and the longitudinal side wall 36c.

### (Operation and effect)

The capacitor cooling unit 21A of the second embodiment includes the first flow path forming portion 61 which forms the first flow path 63 along the first wall portion 25 of the coolant flow path forming portion 21 and the second flow path forming portion 62 which communicates with the first flow path forming portion 61 and forms the second flow path 64 along the longitudinal side wall 36c of the capacitor storage portion 22.

Thus, the capacitor storage portion 22 can be cooled not only from the side of the first wall portion 25 of the coolant flow path forming portion 21 but also the side of the longitudinal side wall 36c in the capacitor storage portion 22 in addition to the operation and effect of the first embodiment. As a result, it is possible to more efficiently cool the capacitor 12 stored in the capacitor storage portion 22 while suppressing an increase in size of the device.

### Other Embodiments

The present disclosure is not limited to the configuration of each of the above-described embodiments, and design changes can be made without departing from the scope of the present disclosure.

For example, in each of the above-described embodiments, although a case has been described in which the casing 11 is formed in a rectangular shape in plan view, the shape of the casing 11 in plan view is not limited to the rectangular shape.

Further, in the first embodiment, although a case has been described in which the current sensor 16 is stored in the power module storage space 42, the current sensor 16 may be disposed outside the casing 11. Further, the control board 14 may also be disposed outside the casing 11.

In the first embodiment, although a case has been described in which the capacitor storage space 35 is divided into a plurality of sections by the partition wall 41, the partition wall 41 may be omitted. Similarly, although a case has been described in which the capacitor storage space 35 is filled with the filler, the filler may be omitted.

Further, in the first embodiment, although a case has been described in which the power module cooling unit 21B includes the communication opening portion 47 which allows the power module storage space 42 and the flow path R to communicate with each other, the communication opening portion 47 may be provided as necessary and, for example, the communication opening portion 47 may not be provided.

### Appendix

The casing and the power conversion device described in the embodiments are understood, for example, as below.
(1) According to a first aspect, the casing 11 is the casing 11 of the power conversion device 100 with the capacitor 12 and the power module 13 including: the coolant flow path forming portion 21 in which the flow path R of the coolant is formed; the capacitor storage portion 22 which is integrally formed with a part of the coolant flow path forming portion 21 and in which the capacitor storage space 35 of the capacitor 12 is formed; and the cover portion 23 defining the power module storage space 42 storing at least the power module 13 together with the remaining part of the coolant flow path forming portion 21 and the capacitor storage portion 22, wherein the coolant flow path forming portion 21 includes the capacitor cooling unit 21A which is configured to cool the capacitor storage portion 22 and the power module cooling unit 21B which is configured to cool the power module 13.

As the power conversion device 100, for example, an inverter device, a converter device, and a device obtained by combining the inverter and the converter are exemplified.

Accordingly, it is possible to cool both the capacitor 12 and the power module 13 by the coolant flow path forming portion 21. Further, since the capacitor storage portion 22 and part of the coolant flow path forming portion 21 are integrally formed with each other, it is possible to define the capacitor storage space 35 by efficiently using part of the coolant flow path forming portion 21. Further, since the power module storage space 42 is formed by efficiently using the remainder of the coolant flow path forming portion 21 and the capacitor storage portion 22 in addition to the cover portion 23, it is possible to form the power module storage space 42 in a compact size. Further, since it is possible to form the outer shell of the casing 11 by the cover portion 23, the capacitor storage portion 22, and the coolant flow path forming portion 21, it is not necessary to separately provide a casing that covers the capacitor cooling structure from the outside. Thus, it is possible to suppress an increase in size while efficiently cooling the capacitor 12.

(2) According to a second aspect, the casing 11 is the casing 11 of (1), wherein the capacitor cooling unit 21A may include the first flow path forming portion 61 forming the first flow path 63 along the first wall portion 25 of the coolant flow path forming portion 21 and the second flow path forming portion 62 communicating with the first flow path forming portion 61 and forming the second flow path 64 along the side wall of the capacitor storage portion 22.

Accordingly, the capacitor storage portion 22 can be cooled not only from the side of the first wall portion 25 of the coolant flow path forming portion 21 but also the side of the longitudinal side wall 36c in the capacitor storage portion 22. As a result, it is possible to more efficiently cool the capacitor 12 stored in the capacitor storage portion 22 while suppressing an increase in size.

(3) According to a third aspect, the casing 11 is the casing 11 of (1) or (2), wherein the power module cooling unit 21B may include the communication opening portion 47 allowing the power module storage space 42 to communicate with the flow path R.

Accordingly, it is possible to allow the cooling fin 48 of the power module 13 to directly contact the coolant and to more efficiently cool the power module 13.

(4) According to a fourth aspect, the casing 11 is the casing 11 of any one of (1) to (3), wherein the cover portion 23 may include the through hole 45 through which a conductor to be connected to the power module 13 is passed, and wherein the power module storage space 42 may be allowed to store the current sensor 16 measuring a current flowing through the conductor.

Accordingly, since it is possible to store the current sensor 16 in the power module storage space 42, it is also possible to cool the current sensor 16 by allowing, for example, the current sensor 16 to contact the coolant flow path forming portion 21. Thus, since the installation space is small compared to the case in which a cooling mechanism for cooling the current sensor 16 is separately provided, it is possible to improve the degree of freedom when installing the casing 11.

(5) According to a fifth aspect, the casing 11 is the casing 11 of any one of (1) to (4), wherein the capacitor storage portion 22 may include the wall portion 41 dividing the capacitor storage space 35 into a plurality of sections.

As the wall portion 41, for example, a partition wall can be exemplified.

Accordingly, the heat of the capacitor 12 stored in the capacitor storage portion 22 is transferred to the capacitor cooling unit 21A via the partition wall 41. Thus, it is possible to more efficiently cool the capacitor 12.

(6) According to a sixth aspect, the power conversion device 100 includes: the casing 11 of any one of (1) to (5); the capacitor 12 which is stored in the capacitor storage space 35; and the power module 13 which is stored in the power module storage space 42.

Accordingly, the power conversion device 100 including the capacitor 12 and the power module 13 can be made compact.

(7) According to a seventh aspect, the power conversion device 100 is the power conversion device 100 of (6), wherein the capacitor storage space 35 may be filled with the filler 46.

Accordingly, the filler contacts the periphery of the capacitor 12 and the filler 46 contacts each wall portion of the capacitor storage portion 22. Therefore, since the heat of the capacitor 12 is transferred to the wall portion 41 and the capacitor cooling unit 21A via the filler, it is possible to further improve the cooling efficiency compared to the case in which the filler 46 is not filled.

### Industrial Applicability

The present disclosure relates to a casing and a power conversion device. According to the casing of the present disclosure, it is possible to suppress an increase in size while efficiently cooling a capacitor.

### Reference Signs List

11 Casing
12 Capacitor
13 Power module
14 Control board
15 Bus bar
16 Current sensor
21 Coolant flow path forming portion
21A Capacitor cooling unit
21B Power module cooling unit
22 Capacitor storage portion
23 Cover portion
25 First wall portion
26 Second wall portion
27a to 27d Side wall
28 Coolant flow path forming portion body
29 Lid portion
30 Flow path recess portion
31 Lid body
32 Coolant inlet
33 Coolant outlet
35 Capacitor storage space
36c Longitudinal side wall
36b, 36d Traverse side wall
37 Ceiling wall
38 Opening portion
39 Terminal portion
41 Partition wall (wall portion)
42 Power module storage space
43a Longitudinal cover side wall
43b, 43d Traverse cover side wall
44 Cover ceiling wall
45 Through hole
46 Filler
47 Communication opening portion
48 Cooling fin
51 Module cooling flow path
52 Capacitor cooling flow path
53 Connection flow path
54 Capacitor flow path recess portion
55 First flow path wall
56 Second flow path wall
56t, 57t End portion
57, 58 Edge portion
61 First flow path forming portion
62 Second flow path forming portion
63 First flow path
64 Second flow path
100 Power conversion device
R Flow path

## Claims

1. A casing of a power conversion device with a capacitor and a power module, comprising:
a coolant flow path forming portion in which a flow path of coolant is formed;
a capacitor storage portion which is integrally formed with a part of the coolant flow path forming portion and in which a capacitor storage space of the capacitor is formed; and
a cover portion defining a power module storage space storing at least the power module together with the remaining part of the coolant flow path forming portion and the capacitor storage portion,
wherein the coolant flow path forming portion includes a capacitor cooling unit which is configured to cool the capacitor storage portion and a power module cooling unit which is configured to cool the power module.

2. The casing according to claim 1,
wherein the capacitor cooling unit includes a first flow path forming portion forming a first flow path along a first wall portion of the coolant flow path forming portion and a second flow path forming portion communicating with the first flow path forming portion and forming a second flow path along a side wall of the capacitor storage portion.

3. The casing according to claim 1 or 2,
wherein the power module cooling unit includes a communication opening portion allowing the power module storage space to communicate with the flow path.

4. The casing according to any one of claims 1 to 3,
wherein the cover portion includes a through hole through which a conductor to be connected to the power module is passed, and
wherein the power module storage space is allowed to store a current sensor measuring a current flowing through the conductor.

5. The casing according to any one of claims 1 to 4,
wherein the capacitor storage portion includes a wall portion dividing a capacitor storage space into a plurality of sections.

6. A power conversion device comprising:
the casing according to any one of claims 1 to 5;
a capacitor which is stored in the capacitor storage space; and
a power module which is stored in the power module storage space.

7. The power conversion device according to claim 6,
wherein the capacitor storage space is filled with a filler.
